# EUROPEAN PATENT APPLICATION

(11) **EP 2 690 943 A1**
(43) Date of publication of application: **29.01.2014**
(21) Application number: 12760976.6
(22) Date of filing: 13.03.2012
(51) Int. Cl.: H05K 9/00

(54) **HIGH-FREQUENCY COMMUNICATION DEVICE**

(30) Priority: 23.03.2011 JP 2011063664
(71) Applicant: Furukawa Electric Co., Ltd., Chiyoda-ku Tokyo 100-8322 (JP); Furukawa Automotive Systems Inc., Shiga 522-0242 (JP)
(72) Inventor: INOUE Daisuke, Tokyo 100-8322 (JP)
(74) Representative: Jordan, Volker Otto Wilhelm
(86) International application number: PCT/JP2012/056437
(87) International publication number: WO 2012/128127

(57) **Abstract**

Provided is a high-frequency communication device in which the thickness can be reduced even when a plurality of protrusions are provided to the ceiling surface of a shield case, and in which a stable signal can be transmitted and received. A high-frequency communication device comprising a transmission/reception circuit board (10) carrying a transmission/reception circuit for processing a quasi-millimeter-wave or millimeter-wave signal, and a shield case (30) attached so as to cover the transmission/reception circuit on the transmission/reception circuit board (10), protrusions (35) arranged at regular intervals and a radio-wave-absorbing sheet (36) being provided on an inner surface (32a) of the shield case (30) facing the transmission/reception circuit board (10).

## Description

### Technical Field

The present disclosure relates to a high-frequency communication device including a transmitting and receiving circuit and a shield case. The transmitting and receiving circuit, which processes a signal having a bandwidth of a quasi-millimeter-wave or millimeter-wave, is mounted inside the high-frequency communication device and is accommodated in the shield case.

### Background Art

In recent years, a sensor (high-frequency communication device) for driving assistance that detects an obstacle near the vehicle has become well known. Such a high-frequency communication device is provided with a transmitting and receiving antenna on a back surface thereof (i.e., an outer surface of the device) and a transmitting and receiving circuit board, on which a transmitting and receiving circuit is mounted, on a front surface thereof (i.e., an inner surface of the device). For example, such an antenna is attached to the vehicle so as to be directed toward outside of the vehicle body, and the antenna transmits a radio wave toward the aforementioned direction.

Such a high-frequency communication device is provided with a metal shield case that entirely covers the circuit board surface. One of the purposes of this feature is to prevent, inter alia: unwanted leakage of a radio wave from the transmitting and receiving circuit on the front surface of the transmitting and receiving circuit board toward outside of the device; undesirable intrusion of a radio wave from outside of the device to the transmitting and receiving circuit; unwanted coupling between components of the aforementioned circuit (components, patterns, and those collectively acting as a component or a pattern); and signal infiltration.

The ceiling surface inside the aforementioned shield case (surface opposing the front surface of the circuit board surface) can be provided with, e.g., a radio wave absorption sheet. One of the purposes of providing the sheet is to prevent, inter alia, unwanted coupling between circuit components, signal infiltration, stable operation of components, and an unnecessary resonance.

Instead of using a radio wave absorption sheet, the entire ceiling surface can be formed with a filter with a plurality of protrusions made of metal or a lossless dielectric or magnetic material. The shape of the protrusions and the spaces therebetween are determined such that the protrusions create a rejection band for a signal at a certain frequency of the transmitting and receiving circuit (see, e.g., Patent Document 1).

### Document List

### Patent Document(s)

Patent Document 1: Japanese Patent No. 3739230

### Summary of Invention

### Technical Problem

When a radio wave absorption sheet is used as described above, a power loss occurs to the main signal. The cost can increase due to use of the sheet, a process of attaching the sheet to the shield case, or the like. When the shield is metal, stable operation can be difficult under certain conditions. For instance, the characteristics of signal amplification components (active components), such as transistors, are largely affected. For the reflective boundary, stringent design conditions, such as those relating to the boundary and distance, are required, when compared with the absorption boundary. A certain distance to the metal surface shield needs to be secured in some cases. When a plurality of protrusions are formed on the entire surface of the ceiling surface instead of using a radio wave absorption sheet, the thickness of the high-frequency communication device is increased by the protruding length of the protrusions. In particular, when a high-frequency communication device contains a component on the circuit board surface that extends to a high position, such as a transistor, the device must have a height greater than the sum of the height of the transistor and the height of the protrusion. Since the adverse effects of the protrusions being close to a metal substance are greater than those of the radio wave absorption sheet, a more distance is needed therebetween for stable operation. Because of the foregoing factors, it has been difficult to decrease the thickness of a high-frequency communication device.

The present disclosure is made in view of the above problems. The present disclosure is directed to providing a low-cost, high-frequency communication device whose thickness can be decreased even if a plurality of protrusions are provided on a shield case. Also, a power loss can be reduced at a specific location of the device, and the device enables stable signal transmitting and receiving by stabilizing operation of the active device thereof.

To solve the above problems, the present disclosure provides a high-frequency communication device including a transmitting and receiving circuit board on which a transmitting and receiving circuit that processes a quasi-millimeter-wave or millimeter-wave signal is mounted, and a shield case attached to cover the transmitting and receiving circuit on the transmitting and receiving circuit board. Protrusions and a radio wave absorption sheet are disposed on an inner surface of the shield case opposing the transmitting and receiving circuit board. The protrusions are periodically arranged.

The radio wave absorption sheet is disposed in at least one area of the shield case opposing an active component of the transmitting and receiving circuit, and the protrusions are disposed in at least one area of the shield case opposing a passive component and/or a circuit pattern section of the transmitting and receiving circuit.

The shield case has no resonant frequency in a used frequency band and has at least one portion in which the protrusions provide a power loss reduction of greater than or equal to 0.3 dB as compared to a case in which an absorption sheet is disposed, the protrusions are disposed in an area opposing the passive component and/or the circuit pattern section of the transmitting and receiving circuit.

A thickness of the radio wave absorption sheet is smaller than a height of the protrusions.

The high-frequency communication device is configured in such a manner that, when the transmitting and receiving circuit board and the shield case are assembled, a distance between a top end portion of each of the protrusions and the transmitting and receiving circuit board is smaller than a height of the active component from the transmitting and receiving circuit board.

A protruding dimension of the protrusions and the radio wave absorption sheet are formed to restrain propagation of a UWB radio wave signal or to absorb the UWB radio wave signal.

A protruding dimension of the protrusions and the radio wave absorption sheet are formed to restrain propagation of a quasi-millimeter UWB radio wave signal or to absorb the quasi-millimeter UWB radio wave signal.

The shield case is formed integrally with the protrusions, which are tapered or have an R portion.

### Advantageous Effects of Invention

In the high-frequency communication device of the present disclosure, protrusions and a radio wave absorption sheet are disposed on an inner surface of the shield case opposing the transmitting and receiving circuit board, and the protrusions are periodically arranged. Accordingly, the protrusions and radio wave absorption sheet can be optimally arranged according to the type and purpose of the components on the transmitting and receiving circuit board so as to maximize the effects of the components.

For example, the radio wave absorption sheet is disposed in an area of the shield case that opposes an active component of the transmitting and receiving circuit so as to enable stable operation. The protrusion is disposed in an area opposing a passive component or circuit pattern section of the transmitting and receiving circuit, thereby enabling reduction of a power loss at a desired location and stable signal transmitting and receiving by the transmitting and receiving circuit. The aforementioned configuration is in particular effective for a communication device that needs to be highly sensitive to weak signals in the broadband, such as radio waves of UWB radar and UWB wireless communication. Also, the high-frequency communication device can be made thinner since interference between an active device with a relatively high height and a protrusion is avoided.

### Brief Description of Drawings

[Fig.1] Fig. 1 is an external perspective view of the high-frequency communication device of the present disclosure.
[Fig. 2] Fig. 2 is an external perspective view of the high-frequency communication device of Fig. 1 without a cover.
[Fig. 3] Fig. 3 is an A-A cross-sectional diagram of Fig. 2, which presents the state of the high-frequency communication device of Fig. 2 with a housing being removed.
[Fig. 4] Fig. 4 is a plan view showing the front surface (shield case side) of the transmitting and receiving circuit board.
[Fig. 5] Fig. 5 is a back view showing the back surface (transmitting and receiving antenna side) of the transmitting and receiving circuit board.
[Fig. 6] Fig. 6 is a plan view showing a ceiling portion inside the shield case.
[Fig. 7] Figs. 7A and 7B are cross-sectional diagrams for comparing the thicknesses of the high-frequency communication device.
[Fig. 8] Fig. 8 is an antenna gain frequency characteristic diagram that presents the performance of the device with or without protrusions and with a radio wave absorption sheet.
[Fig. 9] Fig. 9 is a frequency characteristic diagram showing measurements of the electric field strength at different protrusion heights.
[Fig. 10] Fig. 10 is a diagram showing changes in the electric field strength.

### Description of the Preferred Embodiments

Hereinafter, a high-frequency communication device 1 according to an embodiment of the present disclosure is specifically explained with reference to the drawings. The high-frequency communication device 1 is a small-sized, on-vehicle UWB (Ultra Wide Band: a wireless technology standard for communications at bandwidths over 450 MHz) radar device for detecting obstacles. The bands of the radar are quasi-millimeter bands (24 GHz and 26 GHz band), which are compliant with the radio wave regulations of Japan and other countries.

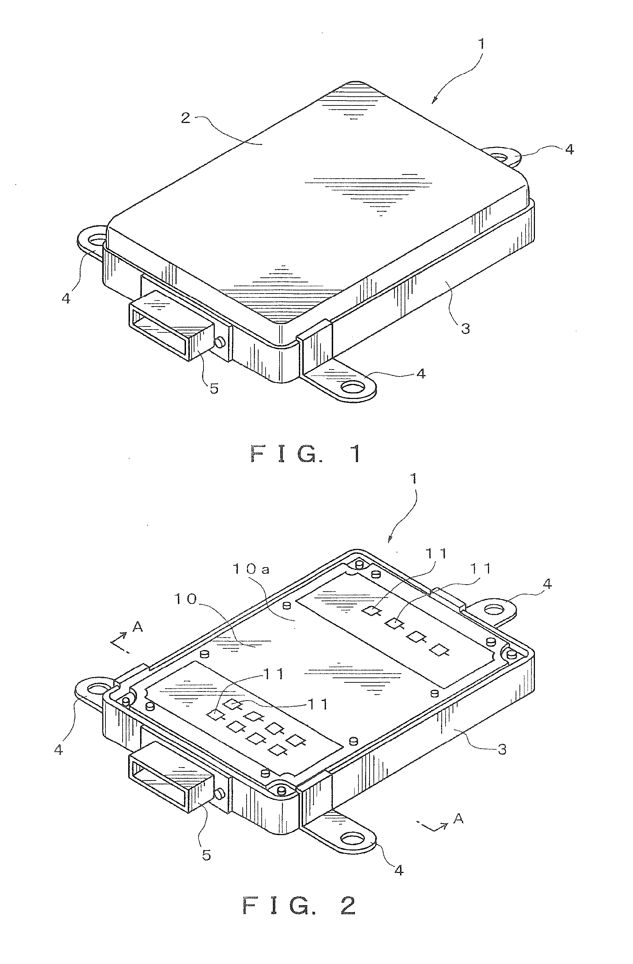

Fig. 1 is an external perspective view of the high-frequency communication device 1 of the present disclosure. The high-frequency communication device 1 is externally covered with a cover 2 made of resin and a housing 3 made of metal, by which the high-frequency communication device 1 is attached to the vehicle.

Fig. 2 shows the high-frequency communication device 1 with the cover 2 being removed. As shown in Fig. 2, three vehicle mounting stays 4 and a transmission connector 5 that transmits a signal detected by the high-frequency communication device 1 are attached to the housing 3. With the cover 2 being removed, a back surface 10a (transmitting and receiving antenna side) of a transmitting and receiving circuit board 10, which will be described in detail below, is exposed. A signal transmitted or received by the high-frequency communication device 1 is transmitted to or received from outside through the cover 2 by a transmitting and receiving antenna 11 provided on the back surface 10a.

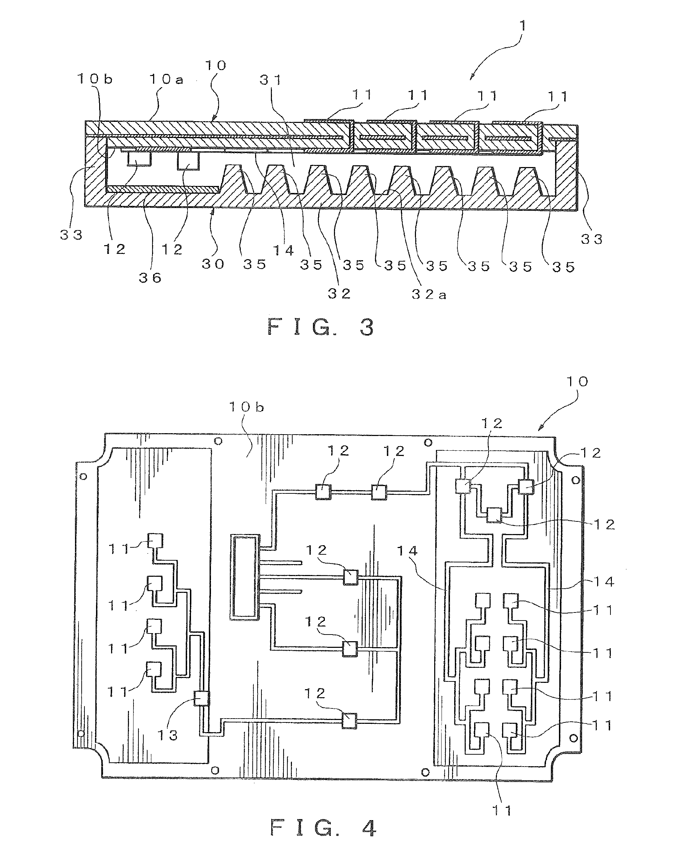

Fig. 3 is an A-A cross-sectional diagram of Fig. 2, which presents the state of the high-frequency communication device 1 of Fig. 2 with the housing 3 being omitted. As shown in Fig. 3, the main portion of the high-frequency communication device 1 includes the transmitting and receiving circuit board 10 and a shield case 30, which entirely covers a front surface 10b of the transmitting and receiving circuit board 10. One of the purposes of providing the shield case 30 is to prevent, inter alia: unwanted leakage of a radio wave toward outside of the device; undesirable intrusion of a radio wave from outside of the device to the transmitting and receiving circuit; unwanted coupling between components of the aforementioned circuit (various components, patterns, and those collectively acting as a component or a pattern); and signal infiltration.

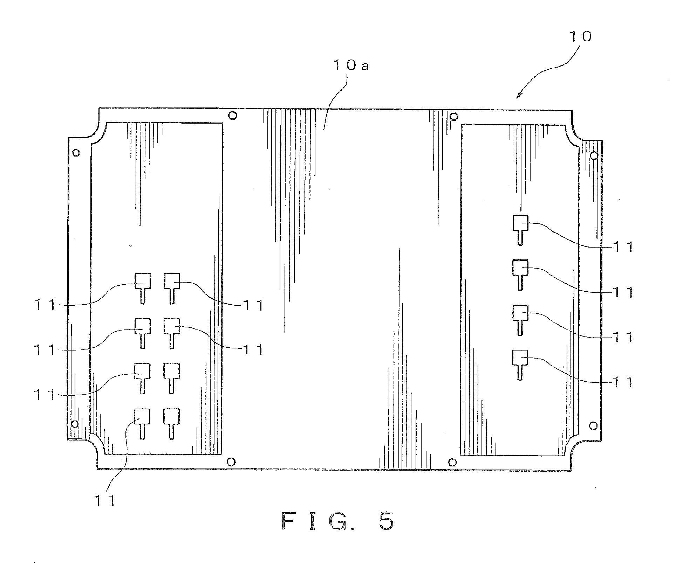

Fig. 4 is a plan view showing the front surface (shield case side) of the transmitting and receiving circuit board, and Fig. 5 is a back view showing the back surface (transmitting and receiving antenna side) of the transmitting and receiving circuit board.

As shown in Figs. 3 and 4, the front surface 10b of the transmitting and receiving circuit board 10 is mounted with a transmitting and receiving circuit that generates a quasi-millimeter wave, a millimeter wave, and the like. The transmitting and receiving circuit includes active components 12, passive components 13, and circuit pattern sections 14. Specifically, the active components 12 include components whose height from the front surface 10b of the circuit board is relatively high (e.g., transistors, ICs, MMICs, and the like). The passive components 13 include components with a low height (e.g., inductors, capacitors, resistors, and the like), and the circuit pattern sections 14 include components with substantially no height (e.g., micro-strip lines, dividers, the transmitting and receiving antenna 11, and the like).

As shown in Figs. 3 and 5, the transmitting and receiving antennas 11 are provided on the back surface 10a of the transmitting and receiving circuit board 10. The transmitting and receiving antennas 11 are electrically connected to the circuit pattern sections 14 on the front surface 10b of the transmitting and receiving circuit board 10.

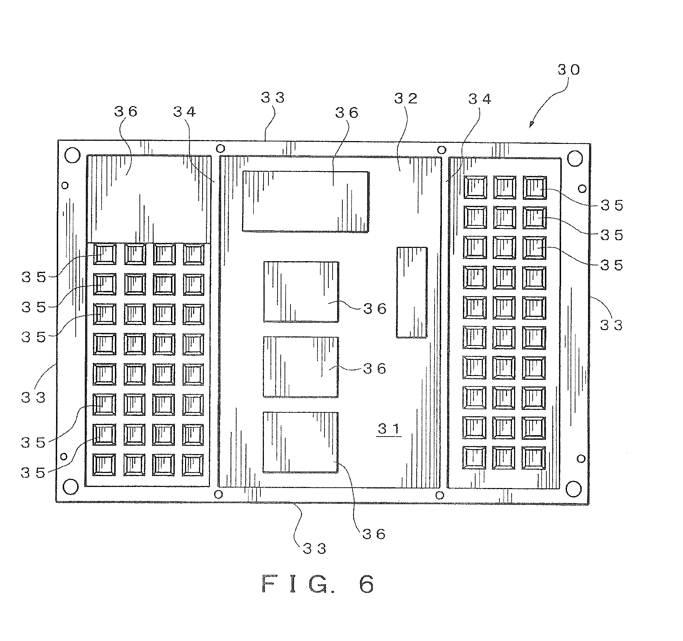

Fig. 6 is a plan view showing the inner surface of a ceiling portion 32 inside the shield case 30.

As shown in Fig. 3, the shield case 30 is formed in a box-like shape having an opening at an upper side thereof. The shield case 30 includes the ceiling portion 32 and side wall portions 33. The ceiling portion 32 opposes the transmitting and receiving circuit board 10 with a space 31 therebetween, and the side wall portions 33 extend from the four sides of the ceiling portion 32 to the transmitting and receiving circuit board 10. As shown in Fig. 6, the shield case 30 has middle wall portions 34 formed so as to separate the space 31 into three. The side wall portions 33 and the middle wall portions 34 are configured in such a manner that, when assembled to the transmitting and receiving circuit board 10, ends thereof come into contact with the front surface 10b of the transmitting and receiving circuit board 10.

The ceiling portion 32 of the shield case 30 has a surface (hereinafter referred to as a "ceiling surface 32a") that opposes the front surface 10b of the transmitting and receiving circuit board 10. A plurality of protrusions 35, which are periodically arranged, and radio wave absorption sheets 36 are disposed at their respective areas on the ceiling surface 32a.

The protrusions 35 are formed integrally with the shield case 30. As can be seen in Fig. 3, a draw taper (inclination) is formed at the side surfaces in the protruding direction of the protrusions 35. At corner portions or the like of the protrusions, R chamfering is appropriately performed. The die of the shield case 30 is of two-split structure, and the direction of die removal (splitting) is aligned with the protruding direction of the protrusions 35. The structure may be made of either resin or metal, and in the former case, the surface is plated with metal, etc., after die forming.

The protrusions 35 of the ceiling surface 32a are disposed in such a manner that they oppose the area of the transmitting and receiving circuit board 10 where the passive components 13 and the circuit pattern sections 14 are mounted in a state where the transmitting and receiving circuit board 10 and the shield case 30 are assembled and not disposed at a portion opposing the area where the active components 12 of the transmitting and receiving circuit are mounted.

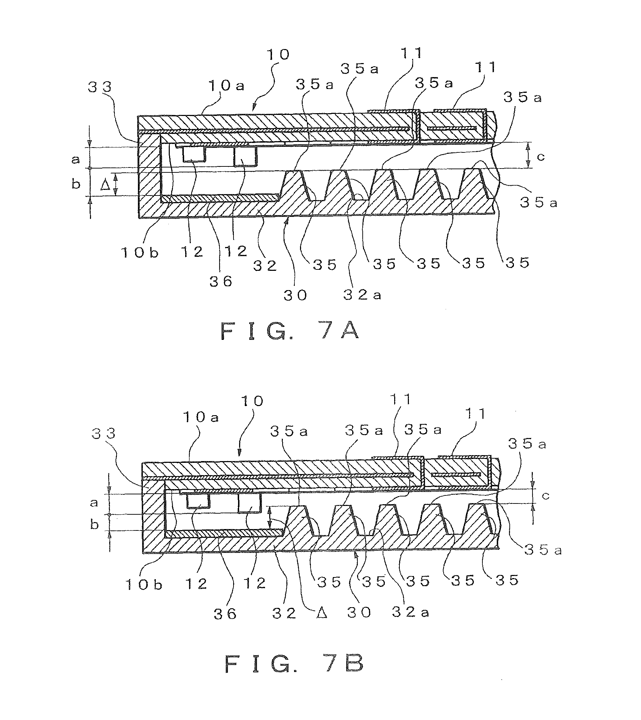

By referring to the schematic diagrams of Figs. 7A and 7B, the thickness of the transmitting and receiving circuit assembled with the shield case will be described. The radio wave absorption sheet 36 absorbs a radio wave that spreads from the transmitting and receiving circuit board 10 to the ceiling surface 32a of the shield case 30. The radio wave absorption sheet 36 is attached to an area of the ceiling surface 32a that opposes the active components 12 of the aforementioned transmitting and receiving circuit.

As schematically shown in Fig. 7A, "c" denotes a distance between the top end portion (peak portion) 35a of the protrusion 35 and the front surface 10b of the transmitting and receiving circuit board 10. Also, "a" denotes a height of the active component 12 from the transmitting and receiving circuit board 10, and "Δ" denotes a difference between the thickness of the radio wave absorption sheet 36 and the height of the protrusion. As will be described below, the thickness of the radio wave absorption sheet 36 is smaller than the height of the protrusion. When the protrusion 35 is provided in an area opposing the active components 12, the shortest distance from the active component 12 to the metallic shield is c - a. As shown in Figs. 7A and 7B, when the radio wave absorption sheet 36 is provided in an area opposing the active components 12, the shortest distance to the active component 12 is "b". If the above two cases are compared under a condition where the distance c remains unchanged, c - a = b, or simply c = a + b, holds in the former, while c = a + b - Δ holds in the latter. The thickness can be made smaller in the latter. In addition, since electric effects are smaller at the absorption boundary than at the reflection boundary in certain situations, b in the latter can be decreased compared with b in the former and the thickness can be made smaller in the latter.

Fig. 7B shows a configuration of the smallest possible thickness. With this configuration, by providing the protrusions 35 above the passive components 13 with a relatively low height and the circuit pattern sections 14 and avoiding interference with the active components 12 whose height is relatively high, the thickness of the device can be determined to satisfy (distance c) < (height a).

Hereinafter, advantages and disadvantages for a case in which the structure of the ceiling surface 32a is constituted by the plurality of protrusions 35 only as well as a case in which the structure of the ceiling surface 32a is constituted by the radio wave absorption sheet 36 only will be explained.

With the configuration in which the plurality of protrusions 35 is provided, a radio wave signal spreads from the transmitting and receiving circuit to the ceiling surface 32a of the shield case 30, and the signal is reflected by the ceiling surface 32a and the protrusions 35, which are made of metal. Due to the periodic arrangement of the protrusions, propagation of certain directional components of an electromagnetic wave along the ceiling surface 32a is restrained in a certain frequency range. The protrusions can be used for shielding against a radio wave from outside, preventing undesirable coupling between circuit components, or preventing an unwanted resonance in a closed shield space. However, as described above, this configuration also has the disadvantage that it is difficult to reduce the thickness of the device. When attaching to the transmitting and receiving circuit board 10, which is mounted with components, at least a space sufficient for accommodating the heights of the components and the protrusions 35 needs to be secured. As the shield is a metal substance and is a reflection boundary in the microscopic sense, adverse effects are greater than those of the radio wave absorption sheet 36, which is an absorption boundary, a greater distance may be needed between the active component and the protrusion in some cases. When the protrusion 35 is arranged so as to be close to a top end portion 12a of the active component 12, operation of the active component 12 may be unstable. It is difficult to decrease the thickness of the device so as to ensure stable operation of the device.

With the configuration in which only the radio wave absorption sheet 36 is provided, a radio wave signal spreads from the transmitting and receiving circuit to the ceiling surface 32a of the shield case 30, and the signal is absorbed by the radio wave absorption sheets 36. However, since the radio wave absorption sheet 36 absorbs some signal power in the circuit, a loss occurs. And disadvantage of this configuration is the weakening of a radio wave transmitted from the transmitting and receiving circuit via the transmitting and receiving antenna 11 to outside of the high-frequency communication device 1 or a radio wave received from outside thereof. A loss occurs in the passive components 13 and the circuit pattern sections 14, where it is in particular necessary to avoid a power loss. The cost can increase due to, inter alia, use of the radio wave absorption sheet 36 and the necessity to perform attachment thereof to the shield case 30. Accordingly, attaching only the radio wave absorption sheets 36 to the ceiling surface 32a of the shield case 30 is also not the best configuration.

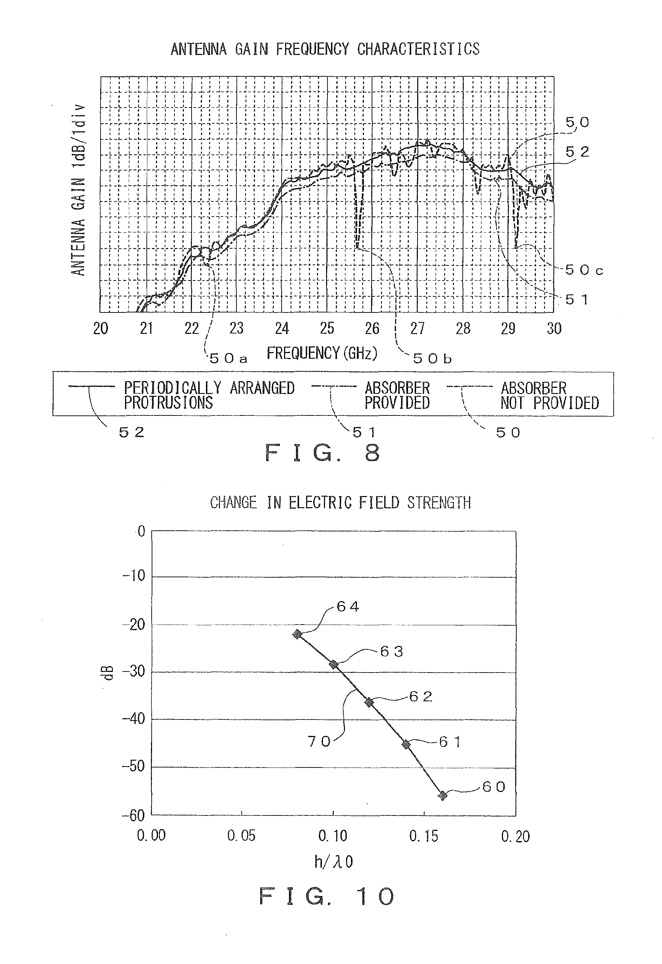

An experiment was conducted for the frequency characteristics of the three configurations where the ceiling surface 32a of the shield case 30 is: (1) not provided with the protrusion 35 or the radio wave absorption sheet 36; (2) entirely covered with only the radio wave absorption sheet 36; and (3) as in the present embodiment, partially provided with the radio wave absorption sheets 36 and the protrusions 35. Fig. 8 is an antenna gain frequency characteristic diagram that presents the performance of the device with or without the protrusion 35 and with the radio wave absorption sheets 36. In this experimental example, the antenna gain includes the pass characteristics of the circuit patterns (micro-strip lines) via which power is supplied to the antenna. In the characteristic diagram of Fig. 8, the horizontal axis represents the frequency (GHz) of a radio wave transmitted from the transmitting and receiving antenna 11, and the vertical axis represents the antenna gain (dBi).

### (1) Not provided with protrusion 35 or radio wave absorption sheet

A numeral 50 (dashed line) denotes the data of this configuration. The gain values of this configuration are greater than those of the other configurations. However, since a radio wave spread from the power supply line causes an undesirable resonance at specific frequencies in a closed space inside the shield, radical changes in the characteristics occur at around 22.4, 25.7, and 29.1 GHz (denoted by numerals 50a, 50b, and 50c, respectively). Especially when a resonance occurs at the used frequency band, stable signal transmission is difficult.

### (2) Only radio wave absorption sheet 36 provided on entire surface

A numeral 51 (dash-dot line) denotes the data of this configuration. A radio wave spread toward the shield case 30 is sufficiently absorbed by the radio wave absorption sheet 36, and no resonance occurs. However, due to the power loss along the power supply line, the gain values are smaller than those of the other configurations. At low antenna gains, the strength of a transmittable and receivable radio wave signal is small, and stable signal transmission is difficult.

### (3) Present embodiment: partially provided with radio wave absorption sheet 36 and protrusions 35

A numeral 52 (solid line) denotes the data of this configuration. In this configuration, propagation of a radio wave from the power supply line is restrained by the periodically arranged protrusions that are provided in an opposing area, and an undesirable resonance in a closed space inside the shield can be prevented. The power loss caused by the radio wave absorption sheets 36 in (2) above does not occur in this configuration. Compared with the data of (2) above, the gain of this configuration is higher. In an area where stable operation takes precedence over power loss reduction, a radio wave absorption sheet can be provided. The configuration where the radio wave absorption sheets 36 and the protrusions 35 are partially provided is the most suitable for practical use.

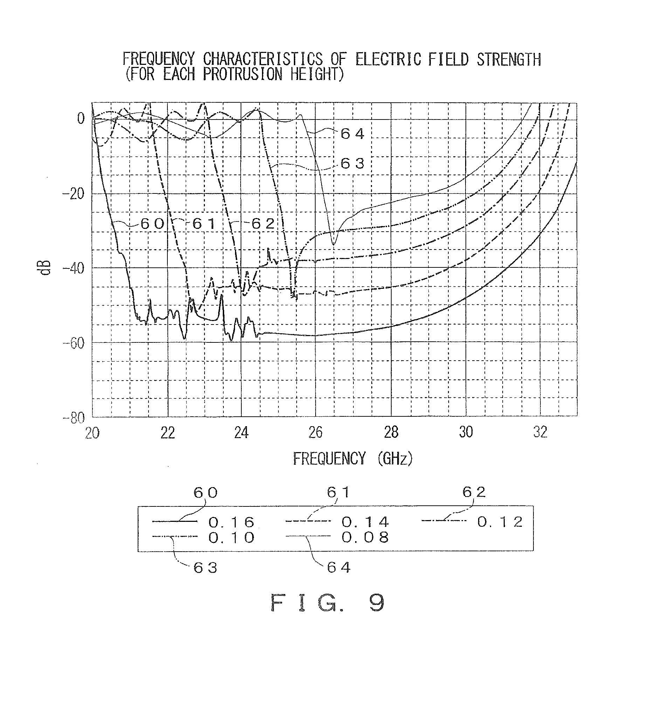

The effects of the height of the plurality of protrusions 35 on restraining of radio wave propagation are hereinbelow explained. Figs. 9 and 10 are diagrams showing changes in an electric field strength of a plane wave which is introduced between the circuit board and the shield plate provided with the periodically arranged protrusions. The electric field strength was measured at a point separate from the incidence plane. Fig. 10 is a diagram showing changes in the value of the electric field strength of the 28 GHz band illustrated in Fig. 9 only.

Fig. 9 shows measurements of the electric field strength at different values of h/λₒ, where "h" denotes the height of the protrusions 35 and "λₒ" denotes the wavelength (numerals 60, 61, 62, 63, and 64 denote 0.16, 0.14, 0.12, 0.10, and 0.08, respectively). The graphs of Figs. 9 and 10 show that as the value of h/λₒ increases, the electric field strength decreases, or the restraining effect increases. In other words, the value of h/λₒ must be greater than a certain value to maximize the propagation restraining effect by the periodic arrangement of the protrusions. In particular, in the configuration of Fig. 9, the broadband capability required for UWB compliance may not be sufficient when the value of h/λₒ is small.

The protrusion height is hereinbelow compared with the thickness of a general radio wave absorption sheet. In this comparison, the electric permittivity of the radio wave absorption sheet material of, e.g., λg/4 type (thin type whose thickness is designed to be substantially 1/4 the value of the effective wavelength) is approximately 13. In this case, the value of H/λₒ is approximately 0.07 where H denotes the thickness of the radio wave absorption sheet. According to the results of h/λₒ in Fig. 9, the protrusions 35 with this height are not sufficient for satisfying the bandwidth requirement for use of UWB. As the propagation restraining effect shown in Fig. 10 is small, the protrusions 35 with this height may not be sufficient for practical use.

Simply decreasing the height h of the protrusions 35 is not advantageous in reducing the thickness of the high-frequency communication device 1. To achieve sufficiently advantageous effects - in particular, to ensure the broadband capability required for UWB compliance - the height of the protrusions 35 needs to be essentially greater than the thickness of the radio wave absorption sheet 36. The high-frequency communication device 1 can be made thinner by suitably arranging the radio wave absorption sheet 36 and the protrusions 35 whose height needs to be set higher than that of the radio wave absorption sheet 36.

In the high-frequency communication device 1 according to the embodiment of the present disclosure, the protrusions 35 are periodically arranged and the radio wave absorption sheet 36 are disposed on the ceiling surface 32a of the shield case 30, which opposes the transmitting and receiving circuit board 10. The protrusions and radio wave absorption sheet can be optimally arranged according to the type and purpose of the components on the transmitting and receiving circuit board 10 so as to maximize the effects of the components. Thereby, a signal can be transmitted stably from the transmitting and receiving antenna 11 on the transmitting and receiving circuit board 10.

The radio wave absorption sheet 36 is disposed in at least one area of the shield case 30 that opposes the active component 12 of the transmitting and receiving circuit. The protrusion 35 is disposed in at least one area of the shield case 30 that opposes the passive component 13 or the circuit pattern section 14 of the transmitting and receiving circuit. Accordingly, the thickness of the high-frequency communication device 1 can be decreased while avoiding interference between the active components 12, whose heights are higher than those of the passive components 13, and the protrusions 35. A power loss can be reduced at a desired location, and stable operation can be chosen over loss reduction at a location where stable operation takes precedence over loss reduction. Also, not using an extra radio wave absorption sheet contributes to cost reduction.

The shield case 30A does not have a resonant frequency in the used frequency band. The protrusion 35 provided in at least one area of the shield case 30 that opposes the passive component 13 or the circuit pattern section of the transmitting and receiving circuit achieves a power loss reduction which is greater than a power loss reduction by the radio wave absorption sheet 36 by 0.3 dB or more. As the strength of a transmittable and receivable radio wave signal can be thereby increased, performance enhancement is possible.

Since the thickness of the radio wave absorption sheet 36 is smaller than the height of the protrusions 35, the protrusions 35 are provided in areas opposing the low-height passive components 13 and the circuit pattern section 14. Also, the radio wave absorption sheet 36 is provided in an area opposing the active component 12 with a high height. The thickness of the high-frequency communication device 1 can be thereby decreased.

The transmitting and receiving circuit board 10 and the shield case 30 are assembled in such a manner that the distance "c" between the top end portion 35a of the protrusion 35 and the front surface 10b of the transmitting and receiving circuit board 10 is smaller than the height "a" of the active component 12 from the front surface 10b of the transmitting and receiving circuit board 10. The thickness of the high-frequency communication device 1 in this configuration is smaller than the thickness thereof in the configuration where only the protrusions 35 are provided on an entire surface of the ceiling surface 32a.

The protruding dimension "h" of the protrusions 35 and the radio wave absorption sheet 36 are formed to restrain propagation of a UWB radio wave signal or to absorb the signal. Such a configuration is suitable for a UWB-based high-frequency wireless device.

The protruding dimension "h" of the protrusions 35 and the radio wave absorption sheet 36 are formed to restrain propagation of a UWB radio wave signal in the quasi-millimeter band or to absorb the signal. Such a configuration optimally enables use of the quasi-millimeter band in compliance with the radio wave regulations of Japan and foreign countries.

Since the shield case 30 is formed integrally with the protrusions 35, which are tapered or have an R portion, the shield case 30 can be thereby produced in a more complicated shape than extrusion forming. Also, the aforementioned method is less expensive than separately forming the shield case and the protrusion.

The high-frequency communication device according to the embodiment of the present disclosure is explained above. However, the present disclosure is not limited to the above-explained embodiment and various modifications and alterations are conceivable based on the technical concept of the present disclosure.

For instance, Fig. 4 shows, as the present embodiment, a transmitting and receiving circuit provided on the transmitting and receiving circuit board 10. The active component 12, the passive component 13, and the like may be disposed at optional locations to address circuit design changes. The locations of the protrusion 35 and the radio wave absorption sheet 36 should be determined according to such design changes.

### List of Reference Signs

- 1: high-frequency communication device
- 2: resin cover
- 3: housing
- 4: vehicle attachment stay
- 5: transmission connector
- 10: transmitting and receiving circuit board
- 10a-: back surface
- 10b: front surface
- 11: transmitting and receiving antenna
- 12: active component
- 13: passive component
- 14: circuit pattern section
- 30: shield case
- 31: space
- 32: ceiling portion
- 32a: ceiling surface
- 33: side wall portion
- 34: middle wall portion
- 35: protrusion
- 35a: top end portion (peak portion) of protrusion
- 36: radio wave absorption sheet
- a: height of active component
- c: distance between top end portion (peak portion) of protrusion and front surface of transmitting and receiving circuit board
- λₒ: wavelength
- h: protrusion height

## Claims

1. A high-frequency communication device comprising:
a transmitting and receiving circuit board on which a transmitting and receiving circuit that processes a quasi-millimeter-wave or millimeter-wave signal is mounted; and
a shield case attached to cover the transmitting and receiving circuit on the transmitting and receiving circuit board,
protrusions and a radio wave absorption sheet being disposed on an inner surface of the shield case opposing the transmitting and receiving circuit board, the protrusions being periodically arranged.

2. The high-frequency communication device according to claim 1, wherein:
the radio wave absorption sheet is disposed in at least one area of the shield case opposing an active component of the transmitting and receiving circuit, and the protrusions are disposed in at least one area of the shield case opposing a passive component and/or a circuit pattern section of the transmitting and receiving circuit.

3. The high-frequency communication device according to claim 2, wherein:
the shield case has no resonant frequency in a used frequency band and has at least one portion in which the protrusions provide a power loss reduction of greater than or equal to 0.3 dB as compared to a case in which an absorption sheet is disposed, the protrusions are disposed in an area opposing the passive component and/or the circuit pattern section of the transmitting and receiving circuit.

4. The high-frequency communication device according to claim 2, wherein:
a thickness of the radio wave absorption sheet is smaller than a height of the protrusions.

5. The high-frequency communication device according to any one of claims 2 to 4, wherein:
the high-frequency communication device is configured in such a manner that, when the transmitting and receiving circuit board and the shield case are assembled, a distance between a top end portion of each of the protrusions and the transmitting and receiving circuit board is smaller than a height of the active component from the transmitting and receiving circuit board.

6. The high-frequency communication device according to any one of claims 1 to 5, wherein:
a protruding dimension of the protrusions and the radio wave absorption sheet are formed to restrain propagation of a UWB radio wave signal or to absorb the UWB radio wave signal.

7. The high-frequency communication device according to any one of claims 1 to 6, wherein:
a protruding dimension of the protrusions and the radio wave absorption sheet are formed to restrain propagation of a quasi-millimeter UWB radio wave signal or to absorb the quasi-millimeter UWB radio wave signal.

8. The high-frequency communication device according to any one of claims 1 to 7, wherein:
the shield case is formed integrally with the protrusions, which are tapered or have an R portion.

## Amended claims

### Amended claims under Art. 19.1 PCT

**1.** (Amended) A high-frequency communication device comprising:
a transmitting and receiving circuit board on which a transmitting and receiving circuit that processes a quasi-millimeter-wave or a millimeter-wave signal is mounted; and
a shield case attached to cover the transmitting and receiving circuit on the transmitting and receiving circuit board,
protrusions and a radio wave absorption sheet being disposed on an inner surface of the shield case opposing the transmitting and receiving circuit board, the protrusions being periodically arranged,
the radio wave absorption sheet being disposed in at least one area of the shield case opposing an active component of the transmitting and receiving circuit, the protrusions being disposed in at least one area of the shield case that opposes at least one of a passive component and a circuit pattern section of the transmitting and receiving circuit,
a thickness of the radio wave absorption sheet being smaller than a height of the protrusion.

**2.** (Amended) A high-frequency communication device comprising:
the transmitting and receiving circuit board on which the transmitting and receiving circuit that processes the quasi-millimeter wave or millimeter wave signal is mounted; and
the shield case attached to cover the transmitting and receiving circuit on the transmitting and receiving circuit board,
the protrusions and the radio wave absorption sheet being disposed on the inner surface of the shield case that opposes the transmitting and receiving circuit board, the protrusions being periodically arranged,
the radio wave absorption sheet being disposed in the at least one area of the shield case opposing the active component of the transmitting and receiving circuit, the protrusions being disposed in the at least one area of the shield case opposing at least one of the passive component and the circuit pattern section of the transmitting and receiving circuit,
wherein the shield case has no resonant frequency in a used frequency band and has at least one portion in which the protrusions provide a power loss reduction of greater than or equal to 0.3 dB as compared to a case in which an absorption sheet is disposed, the protrusions are disposed in an area opposing one of the passive component and the circuit pattern section of the transmitting and receiving circuit; and
the high-frequency communication device is configured in such a manner that, when the transmitting and receiving circuit board and the shield case are assembled, a distance between a top end portion of each of the protrusions and the transmitting and receiving circuit board is smaller than a height of the active component from the transmitting and receiving circuit board.

**3.** (Amended) A high-frequency communication device comprising:
the transmitting and receiving circuit board on which the transmitting and receiving circuit that processes the quasi-millimeter-wave or the millimeter-wave signal is mounted; and
the shield case attached to cover the transmitting and receiving circuit on the transmitting and receiving circuit board,
the protrusions and the radio wave absorption sheet being disposed on the inner surface of the shield case opposing the transmitting and receiving circuit board, the protrusions being periodically arranged,
the radio wave absorption sheet being disposed in the at least one area of the shield case opposing the active component of the transmitting and receiving circuit, the protrusions being disposed in the at least one area of the shield case opposing at least one of the passive component and the circuit pattern section of the transmitting and receiving circuit,
wherein the shield case has no resonant frequency in a used frequency band and has at least one portion in which the protrusions provide a power loss reduction of greater than or equal to 0.3 dB as compared to a case in which an absorption sheet is disposed, the protrusions are disposed in an area opposing one of the passive component and a circuit pattern section of the transmitting and receiving circuit;
the high-frequency communication device is configured in such a manner that, when the transmitting and receiving circuit board and the shield case are assembled, a distance between a top end portion of each of the protrusions and the transmitting and receiving circuit board is smaller than a height of the active component from the transmitting and receiving circuit board; and
a height of the protrusions is greater than or equal to 0.08 λ and smaller than or equal to 0.16 λ.

**4.** (Amended) The high-frequency communication device of any one of claims 1 to 3, wherein:
a protruding dimension of the protrusions and the radio wave absorption sheet are formed to restrain propagation of a UWB radio wave signal or to absorb the UWB radio wave signal.

**5.** (Amended) The high-frequency communication device of any one of claims 1 to 4, wherein:
a protruding dimension of the protrusions and the radio wave absorption sheet are formed to restrain propagation of a quasi-millimeter UWB radio wave signal or to absorb the quasi-millimeter UWB radio wave signal.

**6.** (Amended) The high-frequency communication device of any one of claims 1 to 5, wherein:
the shield case is formed integrally with the protrusions, which are tapered or have an R portion.

**7.** (Cancelled)

**8.** (Cancelled)

The present invention relates to a high-frequency communication device configured in such a manner that the thickness of a radio wave absorption sheet is smaller than the height of protrusions. In this configuration, the protrusions can be disposed in areas opposing a low-height passive component and a circuit pattern, and the radio wave absorption sheet can be disposed in an area opposing a high-height active component. The advantageous effect of the present invention is that the thickness of the high-frequency communication device can be reduced due to the aforementioned configuration.

None of cited references 1 to 3 discloses reduction of the thickness of the high-frequency communication device of the present invention, and such would not have been obvious to one of ordinary skill in the art.
